# EUROPÄISCHE PATENTSCHRIFT

(11) **EP 3 584 648 B1**
(45) Veröffentlichungstag und Bekanntmachung des Hinweises auf die Patenterteilung: **04.08.2021**
(21) Anmeldenummer: 19175692.3
(22) Anmeldetag: 21.05.2019
(51) Int. Cl.: G05B 19/042, G05B 9/02

(54) **SCHALTUNGSANORDNUNG ZUM SCHALTEN EINER ELEKTRISCHEN LAST UND VERFAHREN ZUR ÜBERPRÜFUNG EINES STATUS EINES SICHERHEITSAUSGANGS EINER SCHALTUNGSANORDNUNG**
CIRCUIT ARRANGEMENT FOR SWITCHING AN ELECTRICAL LOAD AND METHOD FOR MONITORING A STATE OF A SAFETY OUTPUT OF A CIRCUIT ASSEMBLY
AGENCEMENT DE CIRCUIT PERMETTANT DE COMMUTER UNE CHARGE ÉLECTRIQUE ET PROCÉDÉ DE VÉRIFICATION DE L'ÉTAT D'UNE SORTIE DE SÉCURITÉ D'UN AGENCEMENT DE CIRCUIT

(30) Priorität: 20.06.2018 DE 102018114781
(43) Veröffentlichungstag der Anmeldung: 25.12.2019
(73) Patentinhaber: Pilz GmbH & Co. KG, 73760 Ostfildern (DE)
(72) Erfinder: Lê, Kim, 73760 Ostfildern (DE); Depner, Paul, 73760 Ostfildern (DE); Bauer, Ralf, 73760 Ostfildern (DE); Röhmann, Stefan, 73760 Ostfildern (DE)
(74) Vertreter: Schäperklaus, Jochen

(56) Entgegenhaltungen:
- EP-A1- 1 594 024
- DE-A1-102015 104 211
- DE-C1- 10 127 233

## Beschreibung

Die vorliegende Erfindung bezieht sich auf eine Schaltungsanordnung zum Schalten einer elektrischen Last, umfassend zumindest ein elektrisches Schaltelement mit einem Steuereingang und einem Ausgang, eine Steuereinheit, die an den Steuereingang angeschlossen ist, wobei die Steuereinheit dazu eingerichtet ist, das Schaltelement derart anzusteuern, dass am Ausgang in einem ersten Schaltzustand des Schaltelements ein erstes Ausgangssignal erzeugbar ist und in einem zweiten Schaltzustand ein zweites Ausgangssignal, welches betragsmäßig kleiner als das erste Ausgangssignal ist, erzeugbar ist, zumindest einen Sicherheitsausgang, der elektrisch mit dem Ausgang des elektrischen Schaltelements verbunden ist und an den die elektrische Last anschließbar ist, eine Entkopplungseinrichtung, die zwischen dem Ausgang des elektrischen Schaltelements und dem Sicherheitsausgang angeordnet ist, sowie eine erste Ausgangssignalerfassungseinrichtung, die an den Ausgang des elektrischen Schaltelements angeschlossen ist. Ferner betrifft die vorliegende Erfindung ein Verfahren zur Überprüfung eines Status eines Sicherheitsausgangs einer Schaltungsanordnung zum Schalten einer daran angeschlossenen elektrischen Last gemäß Anspruch 12. Schaltungsanordnungen zum Schalten einer externen elektrischen Last sind aus dem Stand der Technik in unterschiedlichen Ausführungsformen bekannt. Beispiele hierfür liefern die DE 10 2012 111 070 A1 sowie die DE 10 2007 002 953 A1. Derartige Schaltungsanordnungen werden insbesondere als Ausgangsschaltungen in Geräten eingesetzt, die in der Sicherheits- und Automatisierungstechnik Anwendung finden, um beim Auftreten von Gefahrensituationen ein sicheres Abschalten einer gefahrbringenden technischen Anlage oder Maschine zu bewirken beziehungsweise ein Einschalten der technischen Anlage oder Maschine zu verhindern. Diese insbesondere in der Sicherheits- und Automatisierungstechnik einsetzbaren Geräte können zum Beispiel Meldegeräte oder Sensoren unterschiedlichen Typs sein, mit deren Hilfe Gefahrenbereiche einer Maschine oder einer technischen Anlage überwacht werden können. Bei den Meldegeräten beziehungsweise Sensoren kann es sich zum Beispiel um Not-Aus-Taster, Not-Halt-Taster, Schutztüren, Schaltmatten, Zwei-Hand-Schalter, Lichtgitter, Endlagenschalter und andere Positionsschalter handeln. Diese Meldegeräte beziehungsweise Sensoren bilden aus funktionaler Sicht Signalgeber, die dazu in der Lage sind, binäre Ausgangssignale zu erzeugen, welche über einen Sicherheitsausgang der Schaltungsanordnung zu einer externen Last, beispielsweise an ein Sicherheitsrelais, ein Schütz oder eine Steuerungseinrichtung, insbesondere eine Sicherheitssteuerungseinrichtung, übertragen werden können, so dass ein sicheres Ein- und Ausschalten der technischen Anlage oder Maschine ermöglicht werden kann.

Diese binären Ausgangssignale, die Schaltsignale für die Last bilden, zeichnen sich durch zwei definierte Zustände aus, die beispielsweise durch zwei statische Potentiale definiert sein können. Die binären Zustände sind dabei durch zwei verschiedene Spannungszustände gekennzeichnet, wobei ein erster Zustand dann eingenommen wird, wenn ein definierter Spannungsschwellwert erreicht oder überschritten wird. Dabei handelt es sich um einen so genannten High-Pegel-Zustand. Ein zweiter Zustand wird dann eingenommen, wenn ein definierter Spannungsschwellwert erreicht oder unterschritten wird. Dabei handelt es sich um einen so genannten Low-Pegel-Zustand. Diese binären Schaltzustände geben zum Beispiel an, ob sich eine Person oder ein Objekt in einem zu überwachenden Gefahrenbereich befindet oder nicht oder ob ein Meldegerät, wie zum Beispiel ein Not-Aus- beziehungsweise Not-Halt-Schalter, betätigt worden ist.

Bei der Verwendung einer gattungsgemäßen Schaltungsanordnung zum Beispiel als Ausgangsschaltung in sicherheitsgerichteten Anwendungen ist es erforderlich, die Schaltfähigkeit, insbesondere die Abschaltfähigkeit, des elektrischen Schaltelements periodisch zu überprüfen. Dabei wird im laufenden Betrieb der Maschine oder technischen Anlage von dem Schaltelement ein Abschaltimpuls erzeugt, dessen Zeitdauer so kurz gewählt ist, dass dieses kurzzeitige Abschalten keinerlei Einfluss auf die an den Sicherheitsausgang der Schaltungsanordnung angeschlossene elektrische Last hat. Eine derartige Prüfung wird häufig auch als Dunkeltest bezeichnet. Von einem derartigen Dunkeltest zu unterscheiden ist das betriebsmäßige und somit gewollte Abschalten der Last.

Es hat sich gezeigt, dass insbesondere bei einer kapazitiven Charakteristik der an die Schaltungsanordnung angeschlossenen Last sowie der Anschlussverkabelung die Zeitdauer des Dunkeltests nicht beliebig kurz gewählt werden kann, ohne dass es dabei zu einem unerwünschten Abschalten der Last kommt. Wenn der Abschaltimpuls zum Beispiel mittels eines Tiefpassfiltermittels eines lastseitigen Eingangs, der an den Sicherheitsausgang der Schaltungsanordnung angeschlossen ist, nicht herausgefiltert werden kann, kann nicht zwischen einem Dunkeltest und einem betriebsmäßigen und somit gewollten Abschalten der Last, insbesondere in einer Gefahrensituation, unterschieden werden. Die Last muss allerdings nicht zwingend kapazitiv sein, sondern kann beispielsweise auch einen induktiven Charakter haben. Ausschlaggebend ist, dass die Last nicht sofort auf eine Änderung des Schaltzustandes des Schaltelements reagiert und somit eine Tiefpasscharakteristik aufweist.

Wenn überdies eine Entkopplungseinrichtung in die Schaltungsanordnung integriert ist, die dazu ausgebildet ist, insbesondere während der Durchführung eines Dunkeltests einen Stromfluss von der Last zu dem elektrischen Schaltelement zu verhindern, besteht das Problem, dass Schlüsse, insbesondere Querschlüsse gegen eine elektrische Versorgungsspannung der Schaltungsanordnung, bei einem betriebsmäßigen Abschalten der Last nicht mehr als solche erkannt werden können. Dieses hat eine Verringerung des Diagnosedeckungsgrades zur Folge.

Weitere Schaltungsanordnungen zum Schalten einer elektrischen Last sind zum Beispiel aus der DE 10 2015 104 211 A1, der DE 101 27 233 C1 sowie der EP 1 594 024 A1 bekannt.

Die vorliegende Erfindung macht es sich zur Aufgabe, eine Schaltungsanordnung der eingangs genannten Art zur Verfügung zu stellen, die elektrische Schlüsse, insbesondere Querschlüsse gegen eine elektrische Versorgungsspannung, bei einem betriebsmäßigen Abschalten der Last zuverlässig erfassen kann.

Die Lösung dieser Aufgabe liefert eine gattungsgemäße Schaltungsanordnung mit den Merkmalen des kennzeichnenden Teils des Anspruchs 1. Die Unteransprüche betreffen vorteilhafte Weiterbildungen der Erfindung.

Eine erfindungsgemäße Schaltungsanordnung zum Schalten einer elektrischen Last zeichnet sich dadurch aus, dass die Schaltungsanordnung eine zweite Ausgangssignalerfassungseinrichtung aufweist, die in einem Schaltungspfad zwischen der Entkopplungseinrichtung und dem Sicherheitsausgang angeordnet ist, wobei das Ausgangssignal des Schaltelements vor und hinter der Entkopplungseinrichtung mittels der beiden Ausgangssignalerfassungseinrichtungen erfasst, zurückgelesen und verglichen werden kann. Die erfindungsgemäße Schaltungsanordnung weist somit zusätzlich zu der ersten Ausgangssignalerfassungseinrichtung, mittels derer das von dem Schaltelement ausgegebene Ausgangssignal des elektrischen Schaltelements vor der Entkopplungseinrichtung erfasst werden kann, eine zweite Ausgangssignalerfassungseinrichtung auf, mittels derer das von dem Schaltelement ausgegebene Ausgangssignal darüber hinaus auch im Schaltungspfad hinter der Entkopplungseinrichtung erfasst werden kann. Somit kann das Ausgangssignal des Schaltelements vor und hinter der Entkopplungseinrichtung mittels der beiden Ausgangssignalerfassungseinrichtungen erfasst und zurückgelesen werden. Hierdurch ist es in vorteilhafter Weise möglich, den Status des Sicherheitsausgangs und dabei auch mögliche Querschlüsse, insbesondere Querschlüsse in der Anschlussverkabelung der externen Last, gegen eine elektrische Versorgungsspannung (beispielsweise eine Versorgungsspannung 24 V DC) bei einem betriebsmäßigen (d.h. einem gewollten) Abschalten zu erfassen. Daraus resultiert eine wirksame Erhöhung des Diagnosedeckungsgrades. Wenn der Sicherheitsausgang betriebsmäßig und damit gewollt abgeschaltet wird, erfolgt somit eine Auswertung mittels der ersten Ausgangssignalerfassungseinrichtung und der zweiten Ausgangssignalerfassungseinrichtung. Falls die Signale, die mittels der beiden Ausgangssignalerfassungseinrichtungen erfasst werden, nicht identisch sind, kann der Fehler erkannt und entsprechend eingegrenzt werden. Das erste Ausgangssignal kann insbesondere ein Einschaltsignal für die elektrische Last bilden. Ferner kann das zweite Ausgangssignal insbesondere ein Abschaltsignal für die elektrische Last bilden.

In einer bevorzugten Ausführungsform wird vorgeschlagen, dass die Steuereinheit dazu eingerichtet ist, in einem Testmodus zum Testen der Schaltfähigkeit des elektrischen Schaltelements dieses für eine vorgegebene oder vorgebbare Testdauer von dem ersten Schaltzustand in den zweiten Schaltzustand und von dem zweiten Schaltzustand zurück in den ersten Schaltzustand zu schalten. Dadurch wird die Möglichkeit geschaffen, mittels der Steuereinheit und der ersten Ausgangssignalerfassungseinrichtung einen Dunkeltest der Schaltungsanordnung durchzuführen, um die Schaltfähigkeit des elektrischen Schaltelements der Schaltungsanordnung zu überprüfen. Die Testdauer wird dabei so gewählt, dass der Betrieb der externen Last während der Durchführung des Tests nicht beeinträchtigt wird. Bei der Durchführung des Dunkeltests wird das elektrische Schaltelement somit in der vorstehend beschriebenen Weise kurzzeitig und ohne den Betrieb der Last zu stören abgeschaltet. Der Abschaltstatus des elektrischen Schaltelements wird nur mittels der ersten Ausgangssignalerfassungseinrichtung ausgewertet. Die zweite Ausgangssignalerfassungseinrichtung wird demgegenüber nicht zur Auswertung herangezogen, da sich durch den Tiefpasscharakter der elektrischen Last der Status der zweiten Ausgangssignalerfassungseinrichtung durch das Abschalten nur langsam ändert.

In einer besonders bevorzugten Ausführungsform wird vorgeschlagen, dass die Entkopplungseinrichtung dazu ausgebildet ist, einen Stromfluss von dem Sicherheitsausgang zu dem elektrischen Schaltelement zu unterbinden. Die Entkopplungseinrichtung der Schaltungsanordnung kann dadurch in vorteilhafter Weise wirksam verhindern, dass bei der Durchführung eines Dunkeltests die externe elektrische Last und die Kapazität der Anschlussverkabelung entladen werden müssen.

In einer vorteilhaften Ausführungsform kann vorgesehen sein, dass die Entkopplungseinrichtung als Halbleiterelement ausgebildet ist. Dadurch kann insbesondere eine robuste und funktionssichere Ausgestaltung der Entkopplungseinrichtung erhalten werden. In einer besonders vorteilhaften Ausführungsform besteht die Möglichkeit, dass das Halbleiterelement eine Diode ist, die in Durchlassrichtung zwischen dem Ausgang des Schaltelements und dem Sicherheitsausgang betreibbar ist.

Vorzugsweise kann das elektrische Schaltelement als Transistor, insbesondere als Bipolar-Transistor oder als Feldeffekttransistor, ausgebildet sein. Dadurch wird eine robuste Ausgestaltung des elektrischen Schaltelements geschaffen.

In einer bevorzugten Ausführungsform wird vorgeschlagen, dass die erste Ausgangssignalerfassungseinrichtung an die Steuereinheit angeschlossen ist. Mittels der Steuereinheit ist es möglich, die von der ersten Ausgangssignalerfassungseinrichtung vor der Entkopplungseinrichtung erfassten Ausgangssignale des elektrischen Schaltelements zu verarbeiten und auszuwerten.

In einer besonders bevorzugten Ausführungsform kann vorgesehen sein, dass die zweite Ausgangssignalerfassungseinrichtung an die Steuereinheit angeschlossen ist. Mittels der Steuereinheit ist es möglich, die von der zweiten Ausgangssignalerfassungseinrichtung hinter der Entkopplungseinrichtung erfassten Ausgangssignale des elektrischen Schaltelements zu verarbeiten und auszuwerten. Bei der Durchführung eines Tests bei einem betriebsmäßigen Abschalten des Sicherheitsausgangs überprüft die Steuereinheit, ob beide Ausgangssignalerfassungseinrichtungen denselben Status zurückliefern. Falls die Messergebnisse der beiden Ausgangssignalerfassungseinrichtungen nicht identisch sind, kann der Fehler besser eingegrenzt werden. Es kann insbesondere unterschieden werden, ob das elektrische Schaltelement einen Defekt aufweist oder ob ein Querschluss an einer elektrischen Anschlussleitung vorliegt, mittels derer der Sicherheitsausgang der Schaltungsanordnung mit der elektrischen Last verbunden ist.

Gemäß einem weiteren Aspekt betrifft die vorliegende Erfindung ein Verfahren zur Überprüfung eines Status eines Sicherheitsausgangs einer Schaltungsanordnung zum Schalten einer daran angeschlossenen elektrischen Last, wobei ein elektrisches Schaltelement, das elektrisch mit dem Sicherheitsausgang verbunden ist, in einem ersten Schaltzustand ein erstes Ausgangssignal, welches insbesondere ein Einschaltsignal für die elektrische Last bildet, erzeugt und in einem zweiten Schaltzustand ein zweites Ausgangssignal, welches betragsmäßig kleiner als das erste Ausgangssignal ist und insbesondere ein Abschaltsignal für die elektrische Last bildet, erzeugt.

Eine weitere Aufgabe der vorliegenden Erfindung besteht darin, ein Verfahren der eingangs genannten Art zur Überprüfung eines Status eines Sicherheitsausgangs einer Schaltungsanordnung zum Schalten einer daran angeschlossenen elektrischen Last zur Verfügung zu stellen, bei dem der Status des Sicherheitsausgangs bei elektrischen Schlüssen, insbesondere bei Querschlüssen gegen eine elektrische Versorgungsspannung, bei einem betriebsmäßigen Abschalten des Sicherheitsausgangs sicher erfasst werden können.

Die Lösung dieser Aufgabe liefert ein gattungsgemäßes Verfahren mit den Merkmalen des kennzeichnenden Teils des Anspruchs 12.

Ein erfindungsgemäßes Verfahren zeichnet sich dadurch aus, dass mittels einer ersten Ausgangssignalerfassungseinrichtung ein erstes Signal zwischen dem Schaltelement und einer Entkopplungseinrichtung erfasst wird und mittels einer zweiten Ausgangssignalerfassungseinrichtung ein zweites Signal zwischen der Entkopplungseinrichtung und dem Sicherheitsausgang erfasst wird und die beiden Signale miteinander verglichen werden. Das erfindungsgemäße Verfahren ermöglicht auf zuverlässige Weise eine Überprüfung des Status des Sicherheitsausgangs der Schaltungsanordnung bei einem betriebsmäßigen Einschalten und einem betriebsmäßigen Abschalten desselben. Beispielsweise kann bei einem betriebsmäßigen Abschalten des Sicherheitsausgangs überprüft werden, ob beide Ausgangssignalerfassungseinrichtungen dieselben Signale und damit denselben Status des Sicherheitsausgangs zurückliefern. Falls die Ergebnisse der beiden Ausgangssignalerfassungseinrichtungen nicht identisch sind, kann der Fehler entsprechend eingegrenzt werden. Es kann insbesondere unterschieden werden, ob das elektrische Schaltelement einen Defekt aufweist oder ob ein Querschluss an der elektrischen Anschlussleitung vorliegt, mittels derer der Sicherheitsausgang der Schaltungsanordnung mit der elektrischen Last verbunden ist.

Um die Schaltfähigkeit des elektrischen Schaltelements im Rahmen eines Dunkeltests bestimmen zu können, wird in einer besonders vorteilhaften Ausführungsform vorgeschlagen, dass das elektrische Schaltelement während einer Testdauer kurzzeitig von dem ersten Schaltzustand in den zweiten Schaltzustand geschaltet wird und anschließend wieder von dem zweiten Schaltzustand wieder zurück in den ersten Schaltzustand geschaltet wird, wobei die Testdauer so gewählt wird, dass der Betrieb der elektrischen Last nicht beeinflusst wird und während der Testdauer die Ausgangssignale des Schaltelements mittels der ersten Ausgangssignalerfassungseinrichtung erfasst werden.

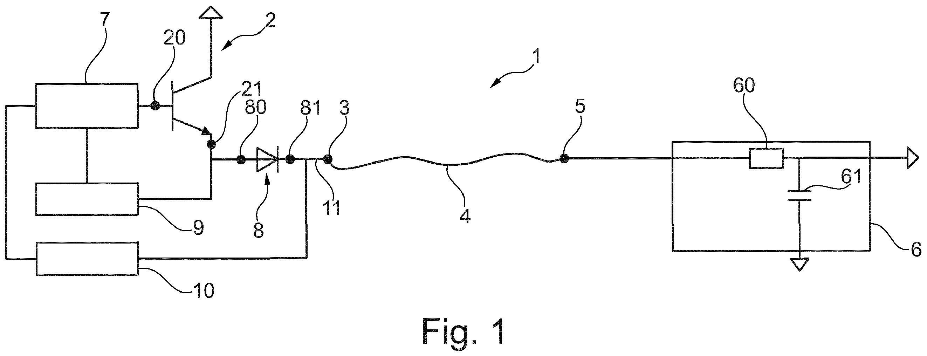

Weitere Merkmale und Vorteile der vorliegenden Erfindung werden deutlich anhand der nachfolgenden Beschreibung eines bevorzugten Ausführungsbeispiels unter Bezugnahme auf die beiliegende Fig. 1, die eine Schaltungsanordnung 1 zum Schalten einer externen elektrischen Last 6 zeigt.

Die Schaltungsanordnung 1, die in diesem Ausführungsbeispiel einkanalig ausgebildet ist, weist ein elektrisches Schaltelement 2 mit einem Steuereingang 20 und einem Ausgang 21 auf, welches vorliegend als Bipolartransistor ausgebildet ist. Der Bipolartransistor ist hierbei als npn-Transistor ausgeführt. Ferner weist die Schaltungsanordnung 1 einen Sicherheitsausgang 3 auf, mittels dessen die Schaltungsanordnung 1 ein Ausgangssignal zum Schalten der elektrischen Last 6 ausgeben kann. Grundsätzlich kann die Schaltungsanordnung 1 auch mehrkanalig ausgebildet sein und demzufolge eine Mehrzahl von Sicherheitsausgängen 3 umfassen, die jeweils ein Ausgangssignal ausgeben können.

Die Schaltungsanordnung 1 kann zum Beispiel in der Sicherheits- und Automatisierungstechnik eingesetzt werden und dazu ausgebildet sein, die an diese angeschlossene elektrische Last 6 sicher zu schalten. Die Schaltungsanordnung 1 kann insbesondere Teil eines in der Sicherheits- und Automatisierungstechnik einsetzbaren Geräts, vorzugsweise eines Meldegeräts oder eines Sensors sein, mittels dessen zum Beispiel Gefahrenbereiche einer Maschine oder technischen Anlage überwacht werden können. Ziel ist es hierbei, in einer Gefahrensituation die elektrische Last 6 sicher abzuschalten. Bei dem Meldegerät kann es sich beispielsweise um einen Not-Aus-Taster handeln, der dazu dient, im Falle einer Gefahrensituation die Maschine oder technische Anlage sicher abzuschalten.

Der zumindest eine Sicherheitsausgang 3 der Schaltungsanordnung 1 ist mittels einer Anschlussleitung 4 an einen Eingang 5 der Last 6 angeschlossen, so dass die Schaltungsanordnung 1 während ihres Betriebs Ausgangssignale ausgeben kann, die über die Anschlussleitung 4 zur elektrischen Last 6 übertragen werden können und entsprechende Schaltereignisse auslösen können. Die elektrische Last 6 kann zum Beispiel ein Relais, ein Schütz, eine Steuerungseinrichtung, insbesondere eine Sicherheitssteuerungseinrichtung, eine technische Anlage oder eine Maschine sein. In dem hier gezeigten Ausführungsbeispiel handelt es sich um eine kapazitive elektrische Last 6, die in Fig. 1 vereinfacht durch ein Ersatzschaltbild mit einem Widerstand 60 und einer Kapazität 61 dargestellt worden ist. Der Widerstand 60 und die Kapazität 61 können auch reale Bauteilkomponenten der Last 6 sein, die aus funktionaler Sicht ein Tiefpass-Filtermittel bilden. Beispielsweise kann es sich bei der kapazitiven Last 6 um einen Eingang einer Steuerungseinrichtung, insbesondere einer speicherprogrammierbaren Steuerungseinrichtung, handeln. Vorzugsweise kann die Steuerungseinrichtung eine Sicherheitssteuerungseinrichtung für sicherheitsgerichtete Anwendungen sein. Wenn die an die Schaltungsanordnung 1 angeschlossene elektrische Last 6 zumindest ein Relais oder ein Schütz umfasst, kann diese auch induktive Lasteigenschaften aufweisen.

Um zu gewährleisten, dass die an die Schaltungsanordnung 1 angeschlossene elektrische Last 6 sicher geschaltet werden kann, wird der Sicherheitsausgang 3 im laufenden Betrieb der Last 6 periodisch abgeschaltet, um die Abschaltfähigkeit des elektrischen Schaltelements 2 der Schaltungsanordnung 1 zu überprüfen. Diese Überprüfung wird häufig auch als "Dunkeltest" bezeichnet. Bei einem derartigen Dunkeltest wird ein kurzer Abschaltimpuls erzeugt, dessen Zeitdauer so kurz gewählt ist, dass ein Einfluss auf die elektrische Last 6 vermieden werden kann. Mit anderen Worten wird der Betrieb der elektrischen Last 6 durch den Abschaltimpuls während der Durchführung des Dunkeltests nicht unterbrochen.

Die Schaltungsanordnung 1 weist ferner eine Steuereinheit 7 auf, die an den Steuereingang 20 des elektrischen Schaltelements 2 angeschlossen ist. Mittels der Steuereinheit 7 kann das Schaltelement 2 derart angesteuert werden, dass in einem ersten Schaltzustand am Ausgang 21 ein erstes Ausgangssignal, welches ein Einschaltsignal für die elektrische Last 6 bildet, erzeugt wird. In einem zweiten Schaltzustand wird ein zweites Ausgangssignal am Ausgang 21 erzeugt, welches betragsmäßig kleiner als das erste Ausgangssignal ist und ein Abschaltsignal für die elektrische Last 6 bildet. Diese Ausgangssignale können insbesondere binäre Schaltsignale sein, die sich durch zwei definierte Zustände auszeichnen, die beispielsweise durch zwei statische Potentiale definiert sein können. Die binären Zustände sind dabei durch zwei verschiedene Spannungszustände charakterisiert, wobei ein erster Zustand dann eingenommen wird, wenn ein definierter Spannungsschwellwert erreicht oder überschritten wird. Dabei handelt es sich um einen so genannten High-Pegel-Zustand. Ein zweiter Zustand wird dann eingenommen, wenn ein definierter Spannungsschwellwert erreicht oder unterschritten wird. Dabei handelt es sich um einen so genannten Low-Pegel-Zustand. Diese binären Schaltzustände geben zum Beispiel an, ob sich eine Person oder ein Objekt in einem zu überwachenden Gefahrenbereich befindet oder nicht oder ob ein Meldegerät, insbesondere ein Not-Aus- beziehungsweise Not-Halt-Schalter, betätigt worden ist.

Zum Zweck der Durchführung eines Dunkeltests zur Überprüfung der Schaltfähigkeit des elektrischen Schaltelements 2 wird dieses von der Steuereinheit 7 in einem Testmodus kurzzeitig von dem ersten Schaltzustand (Einschaltzustand) in den zweiten Schaltzustand (Abschaltzustand) geschaltet und anschließend von dem zweiten Schaltzustand wieder zurück in den ersten Schaltzustand geschaltet. Dadurch wird ein kurzzeitiger Abschaltimpuls erzeugt, der den Betrieb der elektrischen Last 6 nicht beeinflusst.

Die Schaltungsanordnung 1 weist ferner eine erste Ausgangssignalerfassungseinrichtung 9 auf, die an den Ausgang 21 des elektrischen Schaltelements 2 angeschlossen ist. Die erste Ausgangssignalerfassungseinrichtung 9 ist dazu eingerichtet, das Ausgangssignal des Schaltelements 2 zu erfassen. Die erste Ausgangssignalerfassungseinrichtung 9 ist vorzugsweise an die Steuereinheit 7 der Schaltungsanordnung 1 angeschlossen. Durch die Erfassung und Verarbeitung des von der ersten Ausgangssignalerfassungseinrichtung 9 erfassten Ausgangssignals des Schaltelements 2, die insbesondere mittels der Steuereinheit 7 erfolgt, kann auf dessen Schaltzustand und damit auch auf den Status des Sicherheitsausgangs 3 der Schaltungsanordnung 1 geschlossen werden. Es kann also mit anderen Worten überprüft werden, ob an dem Sicherheitsausgang 3 ein Einschaltsignal oder ein Abschaltsignal anliegt. Insbesondere kann der während des Dunkeltests erzeugte Abschaltimpuls mittels der ersten Ausgangssignalerfassungseinrichtung 9 erfasst werden, so dass die Abschaltfähigkeit des Schaltelements 2 überprüft werden kann.

Aufgrund des vorliegend kapazitiven Charakters der an die Schaltungsanordnung 1 angeschlossenen elektrischen Last 6 kann die Zeitdauer des Abschaltimpulses während der Durchführung des Dunkeltests nicht beliebig kurz gewählt werden. Die in Fig. 1 ersatzweise durch den Widerstand 60 und die Kapazität 61 dargestellte kapazitive Last 6 bildet aus funktionaler Sicht ein Tiefpass-Filtermittel, welches unter Umständen nicht dazu in der Lage ist, das kurzzeitige Abschaltsignal während der Durchführung des Dunkeltests auszufiltern, so dass sich der Dunkeltest unmittelbar auf die elektrische Last 6 auswirkt. Folglich kann zwischen der Durchführung des Dunkeltests und einem betriebsmäßigen (d.h. einem gewollten) Abschalten der Last 6 nicht unterschieden werden. An dieser Stelle soll angemerkt werden, dass die Last 6 nicht zwingend kapazitiv sein muss, sondern auch induktiven Charakter haben kann. Ausschlaggebend ist, dass die Last 6 nicht sofort auf eine Änderung des Schaltzustandes des Schaltelements 2 reagiert und somit eine Tiefpasscharakteristik aufweist.

Um dem vorstehend genannten Problem abzuhelfen, ist zwischen dem Ausgang 21 des elektrischen Schaltelements 2 und dem Sicherheitsausgang 3 der Schaltungsanordnung 1 eine Entkopplungseinrichtung 8 angeordnet, die einen Eingang 80 und einen Ausgang 81 aufweist. Die Entkopplungseinrichtung 8 ist in dem hier gezeigten Ausführungsbeispiel als Diode ausgebildet, die in Durchlassrichtung geschaltet ist. Der Eingang 80 der Entkopplungseinrichtung 8 ist mit dem Ausgang 21 des elektrischen Schaltelements 2 verbunden. Ferner ist der Ausgang 81 der Entkopplungseinrichtung 8 mit dem Sicherheitsausgang 3 der Schaltungsanordnung 1 verbunden.

Die vorliegend als Diode ausgebildete Entkopplungseinrichtung 8 verhindert, dass während der Durchführung des Dunkeltests die an die Schaltungsanordnung 1 angeschlossene Last 6 und die Kapazität der Anschlussleitung 4 entladen werden müssen. Mit anderen Worten verhindert die Entkopplungseinrichtung 8, die vorliegend als in Durchlassrichtung geschaltete Diode ausgebildet ist, dass ein elektrischer Strom von der elektrischen Last 6 zu dem elektrischen Schaltelement 2 zurückfließt.

Allerdings besteht hierbei das Problem, dass elektrische Schlüsse - beispielsweise Querschlüsse gegen eine elektrische Versorgungsspannung (zum Beispiel 24 V DC) der Schaltungsanordnung 1 - in demjenigen Teil der Schaltungsanordnung 1 zwischen der Entkopplungseinrichtung 8, insbesondere dem Ausgang 81 der Entkopplungseinrichtung 8, und dem Sicherheitsausgang 3 bei einem betriebsmäßigen und somit gewollten Abschalten des Schaltelements 2, nicht erfasst werden können.

Um dennoch eine Erfassung derartiger elektrischer Schlüsse zu ermöglichen, weist die Schaltungsanordnung 1 zusätzlich zu der ersten Ausgangssignalerfassungseinrichtung 9 eine zweite Ausgangssignalerfassungseinrichtung 10 auf. Die zweite Ausgangssignalerfassungseinrichtung 10 ist an den Schaltungspfad 11 zwischen dem Ausgang 81 der Entkopplungseinrichtung 8 und dem Sicherheitsausgang 3 angeschlossen. Dadurch wird erreicht, dass die zweite Ausgangssignalerfassungseinrichtung 10 den Status des Schaltelements 2 und damit des Sicherheitsausgangs 3 in dem Schaltungspfad 11 hinter der Entkopplungseinrichtung 8, d.h. zwischen dem Ausgang 81 der Entkopplungseinrichtung 8 und dem Sicherheitsausgang 3, erfassen kann. Die zweite Ausgangssignalerfassungseinrichtung 10 ist vorzugsweise ebenfalls an die Steuereinheit 7 der Schaltungsanordnung 1 angeschlossen. Durch die Erfassung und Verarbeitung des von der zweiten Ausgangssignalerfassungseinrichtung 10 erfassten Ausgangssignals des Schaltelements 2, die insbesondere mittels der Steuereinheit 7 erfolgt, kann auf dessen Schaltzustand und damit auch auf den Status des Sicherheitsausgangs 3 der Schaltungsanordnung 1 geschlossen werden.

Mittels der ersten Ausgangssignalerfassungseinrichtung 9 und der zweiten Ausgangssignalerfassungseinrichtung 10 kann somit der Status der Schaltungsanordnung 1 vor und hinter der Entkopplungseinrichtung 8 erfasst und zurückgelesen werden. Hierdurch kann in vorteilhafter Weise zum Beispiel ein Querschluss gegen die Betriebsspannung der Schaltungsanordnung 1 bei einem betriebsmäßigen Abschalten der elektrischen Last 6 erfasst werden. Grundsätzlich kann ein Querschluss der Anschlussleitung 4 sowohl gegen ein Bezugspotential (LOW) als auch gegen ein höheres Potential (HIGH), wie zum Beispiel die Betriebsspannung erfolgen. Ein Querschluss zum Bezugspotential (LOW) kann bei einem betriebsmäßigen Einschalten erkannt werden. Ein Querschluss zum höheren Potential (HIGH), wie zum Beispiel der Betriebsspannung, kann beim betriebsmäßigen Abschalten erfasst werden.

Bei der Durchführung eines Tests bei betriebsmäßigem Abschalten des Sicherheitsausgangs 3 überprüft die Steuereinheit 7, ob beide Ausgangssignalerfassungseinrichtungen 9, 10 dieselben Signale messen und somit denselben Status zurückliefern. Falls die Signale der beiden Ausgangssignalerfassungseinrichtungen 9, 10 nicht identisch sind, kann der Fehler besser eingegrenzt werden. Es kann insbesondere unterschieden werden, ob das elektrische Schaltelement 2 einen Defekt aufweist oder ob ein Querschluss an der elektrischen Anschlussleitung 4 vorliegt, mittels derer der Sicherheitsausgang 3 der Schaltungsanordnung 1 mit der elektrischen Last 6 verbunden ist.

Bei der Durchführung eines Dunkeltests wird das elektrische Schaltelement 2 in der oben beschriebenen Weise kurzzeitig und ohne dabei den Betrieb der Last 6 zu stören abgeschaltet. Der Abschaltstatus des elektrischen Schaltelements 2 wird nur mittels der ersten Ausgangssignalerfassungseinrichtung 9 ausgewertet. Die zweite Ausgangssignalerfassungseinrichtung 10 wird bei der Durchführung eines Dunkeltests nicht zur Auswertung herangezogen, da sich durch den Tiefpasscharakter der elektrischen Last 6 der Status der zweiten Ausgangssignalerfassungseinrichtung 10 nur langsam ändert.

## Patentansprüche

1. Schaltungsanordnung (1) zum Schalten einer elektrischen Last (6), umfassend
- zumindest ein elektrisches Schaltelement (2) mit einem Steuereingang (20) und einem Ausgang (21),
- eine Steuereinheit (7), die an den Steuereingang (20) des elektrischen Schaltelements (2) angeschlossen ist, wobei die Steuereinheit (7) dazu eingerichtet ist, das Schaltelement (2) derart anzusteuern, dass am Ausgang (21) in einem ersten Schaltzustand des Schaltelements (2) ein erstes Ausgangssignal erzeugbar ist und in einem zweiten Schaltzustand ein zweites Ausgangssignal, welches betragsmäßig kleiner als das erste Ausgangssignal ist, erzeugbar ist,
- zumindest einen Sicherheitsausgang (3), der elektrisch mit dem Ausgang (21) des elektrischen Schaltelements (2) verbunden ist und an den die elektrische Last (6) angeschlossen ist,
- eine Entkopplungseinrichtung (8), die zwischen dem Ausgang (21) des elektrischen Schaltelements (2) und dem Sicherheitsausgang (3) angeordnet ist, sowie
- eine erste Ausgangssignalerfassungseinrichtung (9), die an den Ausgang (21) des elektrischen Schaltelements (2) angeschlossen ist,
**dadurch gekennzeichnet, dass** die Schaltungsanordnung (1) eine zweite Ausgangssignalerfassungseinrichtung (10) aufweist, die in einem Schaltungspfad (11) zwischen der Entkopplungseinrichtung (8) und dem Sicherheitsausgang (3) angeordnet ist, wobei das Ausgangssignal des Schaltelements (2) vor und hinter der Entkopplungseinrichtung (8) mittels der beiden Ausgangssignalerfassungseinrichtungen (9, 10) erfasst, zurückgelesen und verglichen werden kann.

2. Schaltungsanordnung (1) nach Anspruch 1, **dadurch gekennzeichnet, dass** das erste Ausgangssignal ein Einschaltsignal für die elektrische Last (6) bildet.

3. Schaltungsanordnung (1) nach einem der Ansprüche 1 oder 2, **dadurch gekennzeichnet, dass** das zweite Ausgangssignal ein Abschaltsignal für die elektrische Last (6) bildet.

4. Schaltungsanordnung (1) nach einem der Ansprüche 1 bis 3, **dadurch gekennzeichnet, dass** die Steuereinheit (7) dazu eingerichtet ist, in einem Testmodus zum Testen der Schaltfähigkeit des elektrischen Schaltelements (2) dieses für eine vorgegebene oder vorgebbare Testdauer von dem ersten Schaltzustand des Schaltelements (2) in den zweiten Schaltzustand des Schaltelements (2) und von dem zweiten Schaltzustand zurück in den ersten Schaltzustand zu schalten.

5. Schaltungsanordnung (1) nach einem der Ansprüche 1 bis 4, **dadurch gekennzeichnet, dass** die Entkopplungseinrichtung (8) dazu ausgebildet ist, einen Stromfluss von dem Sicherheitsausgang (3) zu dem elektrischen Schaltelement (2) zu unterbinden.

6. Schaltungsanordnung (1) nach einem der Ansprüche 1 bis 5, **dadurch gekennzeichnet, dass** die Entkopplungseinrichtung (8) als Halbleiterelement ausgebildet ist.

7. Schaltungsanordnung (1) nach Anspruch 6, **dadurch gekennzeichnet, dass** das Halbleiterelement eine Diode ist, die in Durchlassrichtung zwischen dem Ausgang (21) des Schaltelements (2) und dem Sicherheitsausgang (3) betreibbar ist.

8. Schaltungsanordnung (1) nach einem der Ansprüche 1 bis 7, **dadurch gekennzeichnet, dass** das elektrische Schaltelement (2) als Transistor ausgebildet ist.

9. Schaltungsanordnung (1) nach Anspruch 8, **dadurch gekennzeichnet, dass** der Transistor als Bipolar-Transistor oder als Feldeffekttransistor ausgebildet ist.

10. Schaltungsanordnung (1) nach einem der Ansprüche 1 bis 9, **dadurch gekennzeichnet, dass** die erste Ausgangssignalerfassungseinrichtung (9) an die Steuereinheit (7) angeschlossen ist.

11. Schaltungsanordnung (1) nach einem der Ansprüche 1 bis 10, **dadurch gekennzeichnet, dass** die zweite Ausgangssignalerfassungseinrichtung (10) an die Steuereinheit (7) angeschlossen ist.

12. Verfahren zur Überprüfung eines Status eines Sicherheitsausgangs (3) einer Schaltungsanordnung (1) zum Schalten einer daran angeschlossenen elektrischen Last (6), wobei ein elektrisches Schaltelement (2), das elektrisch mit dem Sicherheitsausgang (3) verbunden ist, in einem ersten Schaltzustand ein erstes Ausgangssignal erzeugt und in einem zweiten Schaltzustand ein zweites Ausgangssignal, welches betragsmäßig kleiner als das erste Ausgangssignal ist, erzeugt, **dadurch gekennzeichnet, dass** mittels einer ersten Ausgangssignalerfassungseinrichtung (9) ein erstes Signal zwischen dem Schaltelement (2) und einer Entkopplungseinrichtung (8) erfasst wird und mittels einer zweiten Ausgangssignalerfassungseinrichtung (10) ein zweites Signal zwischen der Entkopplungseinrichtung (8) und dem Sicherheitsausgang (3) erfasst wird und die beiden Signale miteinander verglichen werden.

13. Verfahren nach Anspruch 12, **dadurch gekennzeichnet, dass** das elektrische Schaltelement (2) während einer Testdauer kurzzeitig von dem ersten Schaltzustand in den zweiten Schaltzustand geschaltet wird und anschließend wieder von dem zweiten Schaltzustand zurück in den ersten Schaltzustand geschaltet wird, wobei die Testdauer so gewählt wird, dass der Betrieb der elektrischen Last (6) nicht beeinflusst wird und während der Testdauer die Ausgangssignale des Schaltelements (2) mittels der ersten Ausgangssignalerfassungseinrichtung (9) erfasst werden.

14. Verfahren nach einem der Ansprüche 12 oder 13, **dadurch gekennzeichnet, dass** das erste Ausgangssignal ein Einschaltsignal für die elektrische Last (6) bildet.

15. Verfahren nach einem der Ansprüche 12 bis 14, **dadurch gekennzeichnet, dass** das zweite Ausgangssignal ein Abschaltsignal für die elektrische Last (6) bildet.

## Claims

1. Circuit arrangement (1) for switching an electrical load (6), comprising:
- at least one electrical switching element (2) with a control input (20) and an output (21),
- a control unit (7) which is connected to the control input (20) of the electrical switching element (2), wherein the control unit (7) is configured to actuate the switching element (2) such that, in a first switching state of the switching element (2), a first output signal can be generated at the output (21), and in a second switching state, a second output signal can be generated which is smaller in amount that the first output signal,
- at least one safety output (3) which is electrically connected to the output (21) of the electrical switching element (2) and to which the electrical load (6) is connected,
- a decoupling device (8) which is arranged between the output (21) of the electrical switching element (2) and the safety output (3), and
- a first output signal detection device (9) which is connected to the output (21) of the electrical switching element (2),
**characterised in that** the circuit arrangement (1) comprises a second output signal detection device (10) which is arranged in a circuit path (11) between the decoupling device (8) and the safety output (3), wherein the output signal of the switching element (2) in front of and behind the decoupling device (8) can be detected, read back and compared by means of the two output signal detection devices (9, 10).

2. Circuit arrangement (1) according to claim 1, **characterised in that** the first output signal forms a switch-on signal for the electrical load (6).

3. Circuit arrangement (1) according to one of claims 1 or 2, **characterised in that** the second output signal forms a switch-off signal for the electrical load (6).

4. Circuit arrangement (1) according to any of claims 1 to 3, **characterised in that** the control unit (7) is configured, in a test mode for testing the switching ability of the electrical switching element (2), to switch this for a predefined or predefinable test duration from the first switching state of the switching element (2) into the second switching state of the switching element (2) and from the second switching state back to the first switching state.

5. Circuit arrangement (1) according to any of claims 1 to 4, **characterised in that** the decoupling device (8) is configured to suppress a current flow from the safety output (3) to the electrical switching element (2).

6. Circuit arrangement (1) according to any of claims 1 to 5, **characterised in that** the decoupling device (8) is configured as a semiconductor element.

7. Circuit arrangement (1) according to claim 6, **characterised in that** the semiconductor element is a diode which can be operated in the passage direction between the output (21) of the switching element (2) and the safety output (3).

8. Circuit arrangement (1) according to any of claims 1 to 7, **characterised in that** the electrical switching element (2) is configured as a transistor.

9. Circuit arrangement (1) according to claim 8, **characterised in that** the transistor is configured as a bipolar transistor or as a field effect transistor.

10. Circuit arrangement (1) according to any of claims 1 to 9, **characterised in that** the first output signal detection device (9) is connected to the control unit (7).

11. Circuit arrangement (1) according to any of claims 1 to 10, **characterised in that** the second output signal detection device (10) is connected to the control unit (7).

12. Method for checking a status of a safety output (3) of a circuit arrangement (1) for switching an electrical load (6) connected thereto, wherein an electrical switching element (2), which is electrically connected to the safety output (3), in a first switching state generates a first output signal and in a second switching state generates a second output signal which is smaller in amount than the first output signal,
**characterised in that** by means of a first output signal detection device (9), a first signal is detected between the switching element (2) and a decoupling device (8), and by means of a second output signal detection device (10), a second signal is detected between the decoupling device (8) and the safety output (3), and the two signals are compared with one another.

13. Method according to claim 12, **characterised in that** during a test duration, the electrical switching element (2) is briefly switched from the first switching state to the second switching state and then back again from the second switching state to the first switching state, wherein the test duration is selected such that the operation of the electrical load (6) is not affected and during the test duration, the output signals of the switching element (2) are detected by means of the first output signal detection device (9).

14. Method according to one of claims 12 or 13, **characterised in that** the first output signal forms a switch-on signal for the electrical load (6).

15. Method according to any of claims 12 to 14, **characterised in that** the second output signal forms a switch-off signal for the electrical load (6).

## Revendications

1. Agencement de circuit (1) pour la commutation d'une charge électrique (6), comprenant
- au moins un élément de commutation (2) électrique avec une entrée de commande (20) et une sortie (21),
- une unité de commande (7) qui est raccordée à l'entrée de commande (20) de l'élément de commutation (2) électrique, dans lequel l'unité de commande (7) est conçue afin de commander l'élément de commutation (2) de telle manière qu'au niveau de la sortie (21) dans un premier état de commutation de l'élément de commutation (2) un premier signal de sortie puisse être généré et dans un second état de commutation un second signal de sortie qui est inférieur en amplitude au premier signal de sortie, puisse être généré,
- au moins une sortie de sécurité (3) qui est reliée de manière électrique à la sortie (21) de l'élément de commutation (2) électrique et à laquelle la charge (6) électrique est raccordée,
- un dispositif de découplage (8) qui est agencé entre la sortie (21) de l'élément de commutation (2) électrique et la sortie de sécurité (3), ainsi que
- un premier dispositif de détection de signal de sortie (9) qui est raccordé à la sortie (21) de l'élément de commutation (2) électrique,
**caractérisé en ce que** l'agencement de circuit (1) présente un second dispositif de détection de signal de sortie (10) qui est agencé dans un trajet de circuit (11) entre le dispositif de découplage (8) et la sortie de sécurité (3), dans lequel le signal de sortie de l'élément de commutation (2) peut être détecté, relu et comparé devant et derrière le dispositif de découplage (8) au moyen des deux dispositifs de détection de signal de sortie (9, 10).

2. Agencement de circuit (1) selon la revendication 1, **caractérisé en ce que** le premier signal de sortie forme un signal de mise en marche pour la charge (6) électrique.

3. Agencement de circuit (1) selon l'une des revendications 1 ou 2, **caractérisé en ce que** le second signal de sortie forme un signal de mise à l'arrêt pour la charge (6) électrique.

4. Agencement de circuit (1) selon l'une des revendications 1 à 3, **caractérisé en ce que** l'unité de commande (7) est conçue afin de commuter dans un mode de test pour le test de la capacité de commutation de l'élément de commutation (2) électrique celui-ci pour une durée de test prédéfinie ou prédéfinissable du premier état de commutation de l'élément de commutation (2) dans le second état de commutation de l'élément de commutation (2) et du second état de commutation de nouveau dans le premier état de commutation.

5. Agencement de circuit (1) selon l'une des revendications 1 à 4, **caractérisé en ce que** le dispositif de découplage (8) est réalisé afin d'éviter un flux de courant de la sortie de sécurité (3) à l'élément de commutation (2) électrique.

6. Agencement de circuit (1) selon l'une des revendications 1 à 5, **caractérisé en ce que** le dispositif de découplage (8) est réalisé comme élément semi-conducteur.

7. Agencement de circuit (1) selon la revendication 6, **caractérisé en ce que** l'élément semi-conducteur est une diode qui peut être utilisée dans le sens de passage entre la sortie (21) de l'élément de commutation (2) et la sortie de sécurité (3).

8. Agencement de circuit (1) selon l'une des revendications 1 à 7, **caractérisé en ce que** l'élément de commutation (2) électrique est réalisé comme transistor.

9. Agencement de circuit (1) selon la revendication 8, **caractérisé en ce que** le transistor est réalisé comme transistor bipolaire ou comme transistor à effet de champ.

10. Agencement de circuit (1) selon l'une des revendications 1 à 9, **caractérisé en ce que** le premier dispositif de détection de signal de sortie (9) est raccordé à l'unité de commande (7).

11. Agencement de circuit (1) selon l'une des revendications 1 à 10, **caractérisé en ce que** le second dispositif de détection de signal de sortie (10) est raccordé à l'unité de commande (7).

12. Procédé de vérification d'un état d'une sortie de sécurité (3) d'un agencement de commutation (1) pour la commutation d'une charge (6) électrique raccordée à celui-ci, dans lequel un élément de commutation (2) électrique qui est relié de manière électrique à la sortie de sécurité (3), génère dans un premier état de commutation un premier signal de sortie et dans un second état de commutation un second signal de sortie qui est inférieur en amplitude au premier signal de sortie, **caractérisé en ce qu'**au moyen d'un premier dispositif de détection de signal de sortie (9) un premier signal est détecté entre l'élément de commutation (2) et un dispositif de découplage (8) et au moyen d'un second dispositif de détection de signal de sortie (10) un second signal est détecté entre le dispositif de découplage (8) et la sortie de sécurité (3), et les deux signaux sont comparés l'un à l'autre.

13. Procédé selon la revendication 12, **caractérisé en ce que** l'élément de commutation (2) électrique est monté pendant une durée de test à court terme du premier état de commutation dans le second état de commutation et est remonté ensuite de nouveau du second état de commutation dans le premier état de commutation, dans lequel la durée de test est choisie de sorte que le fonctionnement de la charge (6) électrique ne soit pas influencé et pendant la durée de test les signaux de sortie de l'élément de commutation (2) soient détectés au moyen du premier dispositif de détection de signal de sortie (9).

14. Procédé selon l'une des revendications 12 ou 13, **caractérisé en ce que** le premier signal de sortie forme un signal de mise en marche pour la charge (6) électrique.

15. Procédé selon l'une des revendications 12 à 14, **caractérisé en ce que** le second signal de sortie forme un signal de mise à l'arrêt pour la charge (6) électrique.
